# EUROPÄISCHE PATENTSCHRIFT

(11) **EP 2 678 888 B1**
(45) Veröffentlichungstag und Bekanntmachung des Hinweises auf die Patenterteilung: **20.01.2016**
(21) Anmeldenummer: 12705306.4
(22) Anmeldetag: 22.02.2012
(51) Int. Cl.: H01L 35/32, F01N 5/02

(54) **THERMOELEKTRISCHES MODUL FÜR EINEN THERMOELEKTRISCHEN GENERATOR EINES FAHRZEUGES**
THERMOELECTRIC MODULE FOR A THERMOELECTRIC GENERATOR OF A VEHICLE
MODULE THERMOÉLECTRIQUE POUR UN GÉNÉRATEUR THERMOÉLECTRIQUE D'UN VÉHICULE

(30) Priorität: 25.02.2011 DE 102011012448
(43) Veröffentlichungstag der Anmeldung: 01.01.2014
(73) Patentinhaber: Continental Automotive GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2012/053033
(87) Internationale Veröffentlichungsnummer: WO 2012/113843

(56) Entgegenhaltungen:
- DE-A1- 3 809 310
- DE-A1-102006 039 024
- US-A- 3 601 887

## Beschreibung

Die vorliegende Erfindung betrifft ein thermoelektrisches Modul, insbesondere für den Einsatz in einem thermoelektrischen Generator, der in einem Fahrzeug zum Einsatz kommt.

Das Abgas aus einer Verbrennungskraftmaschine eines Kraftfahrzeuges besitzt thermische Energie, welche mittels eines thermoelektrischen Generators in elektrische Energie umgewandelt werden kann, beispielsweise um eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeuges Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p-dotiert und n-dotiert), die auf ihrer Oberseite und Unterseite (hin zur Heißseite bzw. Kaltseite) wechselseitig mit elektrisch leitenden Brücken versehen sind, und die die kleinste thermoelektrische Einheit bzw. ein thermoelektrisches Element bilden. Thermoelektrische Materialien sind von einer Art, dass diese thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n-dotiert und p-dotiert) in direkten elektrischen Kontakt gebracht. Mittels eines angeschlossenen elektrischen Lastwiderstands kann der Stromkreis geschlossen und somit elektrische Leistung abgegriffen werden.

Um eine dauerhafte Einsatzfähigkeit der Halbleiterelemente zu gewährleisten, wird zwischen den elektrisch leitenden Brücken und dem thermoelektrischen Material regelmäßig eine Diffusionsbarriere angeordnet, die ein Diffundieren von in den elektrischen Brücken bzw. im Lot enthaltenem Material in das thermoelektrische Material verhindert. Damit wird einem Effektivitätsverlust bzw. einem funktionellen Versagen des Halbleitermaterials bzw. des thermoelektrischen Elements entgegengewirkt. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brücken, Isolierung und ggf. weiteren Gehäuseelementen. Dieser Zusammenbau zahlreicher einzelner Komponenten erfordert auch eine genaue Abstimmung der einzelnen Bauteiltoleranzen und eine Berücksichtigung der Wärmeübergänge von der Heißseite zur Kaltseite sowie der hinreichenden Kontaktierung der elektrisch leitenden Brücken, so dass ein Stromfluss durch das thermoelektrische Modul erzeugt werden kann.

Für die Anordnung solcher Halbleiterelemente in einem thermoelektrischen Modul sind regelmäßige Gehäuse, Wände und/oder Stützrohre zur äußeren Begrenzung des Moduls vorgesehen, an denen die Halbleiterelemente befestigt sind. Dies führt insbesondere dazu, dass bei der Fertigung hohe Toleranzanforderungen gegeben sind, um einerseits eine passgenaue Anordnung der Halbleiterelemente mit Bezug auf die elektrischen Verbindungen sowie die Position der Gehäuse zu realisieren. Problematisch ist darüber hinaus, dass infolge der unterschiedlichen thermischen Belastungen der äußeren und inneren Gehäuseteile auch unterschiedliche Ausdehnungsverhalten dieser Komponenten kompensiert werden müssen, ohne dass besonders hohe Spannungen in das thermoelektrische Material eingeleitet werden. Gerade im Hinblick auf eine solche Fertigung von thermoelektrischen Modulen ist gewünscht, die Vielzahl von Bauteilen leicht miteinander kombinieren zu können, die Lagerung und die Handhabung zu vereinfachen und auch beim Zusammenbau eine leichte, stabile Struktur zu erzeugen.

Bei thermoelektrischen Modulen wird der Wirkungsgrad im Wesentlichen durch den Wärmestrom von Heißseite zu Kaltseite bestimmt. Die Heißseite wird regelmäßig von einem gasförmigen Abgas und die Kaltseite von einem flüssigen Kühlmittel beaufschlagt. Da die Wärmekapazität eines gasförmigen Mediums regelmäßig wesentlich geringer ist als die eines flüssigen Mediums ist es vorteilhaft, die Fläche für den Wärmeübergang des gasförmigen Mediums zu erhöhen. Aus diesem Grund kann der Wirkungsgrad eines thermoelektrischen Moduls gerade dann deutlich verbessert werden, wenn an der Heißseite eine größere Wärmeübergangsfläche bereitgestellt wird.

US 3 601 887 A, offenbart ein Verfahren zur Herstellung eines thermoelektrischen Elements durch heißisostatisches Pressen.

Hiervon ausgehend ist es Aufgabe der vorliegenden Erfindung, die mit Bezug auf den Stand der Technik geschilderten Probleme zumindest teilweise zu lösen. Insbesondere soll ein thermoelektrisches Modul angegeben werden, das technisch einfach herstellbar ist, eine reduzierte Teilezahl aufweist, für den gewünschten Einsatz stabil ist und/oder zudem einen hohen Wirkungsgrad aufweist, um aus der thermischen Energie eines Abgases elektrische Energie zu erzeugen.

Diese Aufgaben werden gelöst mit einem thermoelektrischen Modul gemäß den Merkmalen des Patentanspruchs 1. Weitere vorteilhafte Ausgestaltungen der Erfindung sind in den abhängig formulierten Patentansprüchen angegeben. Die in den Patentansprüchen einzeln aufgeführten Merkmale sind in beliebiger, technologisch sinnvoller, Weise miteinander kombinierbar und zeigen weitere Ausgestaltungen der Erfindung auf. Die

Beschreibung, insbesondere im Zusammenhang mit den Figuren, erläutert die Erfindung weiter und führt ergänzende Ausführungsbeispiele der Erfindung an.

Das erfindungsgemäße thermoelektrische Modul weist eine Innenumfangsfläche, eine Achse und eine Außenumfangsfläche auf, wobei in Richtung der Achse und zwischen der Innenumfangsfläche und der Außenumfangsfläche eine Mehrzahl von Halbleiterelementen mit thermoelektrischem Material angeordnet und elektrisch miteinander wechselweise verbunden ist. Zudem weist wenigstens ein Teil der Halbleiterelemente zumindest ein inneres Rahmenteil auf, so dass die inneren Rahmenteile eine unterbrochene Innenumfangsfläche bilden. Die Innenumfangsfläche bildet eine Kaltseite des thermoelektrischen Moduls und weiter ist zumindest an der unterbrochenen Innenumfangsfläche eine forminstabile Hülle vorgesehen.

Das thermoelektrische Modul stellt insbesondere eine separate Baueinheit eines thermoelektrischen Generators dar. Bevorzugt ist dabei, dass das thermoelektrische Modul einen Anschluss aufweist, mit dem ein solches thermoelektrisches Modul ggf. mit einer Vielzahl weiterer thermoelektrischer Module elektrisch verschaltet werden kann. Innerhalb des thermoelektrischen Moduls ist also insbesondere die elektrische Verbindung bzw. Verschaltung aller dort integrierten Halbleiterelemente realisiert. Ein solches thermoelektrisches Modul wird nun einerseits einem Kühlmedium und andererseits einem Heißmedium ausgesetzt. Hierbei steht insbesondere im Fokus, dass das thermoelektrische Modul über seine Innenumfangsfläche mit einem Kühlmedium und über seine Außenumfangsfläche mit einem Heißmedium (insbesondere Abgas) in Kontakt gebracht wird bzw. von diesen Medien durchströmt/umströmt wird. Damit bildet praktisch die Innenumfangsfläche eine sogenannten Kaltseite und die Außenumfangsfläche eine sogenannte Heißseite des thermoelektrischen Moduls aus.

Weiterhin ist bevorzugt, dass das thermoelektrische Modul länglich ausgeführt ist, also beispielsweise nach Art einer Schiene oder eines Rohrs. Auch wenn ganz besonders bevorzugt ist, dass das thermoelektrische Modul in etwa wie ein Zylinder bzw. ein Rohr gestaltet ist, ist eine solche Form nicht zwingend. Insbesondere können auch ovale Querschnitte oder polygonale Querschnitte für ein solches thermoelektrisches Modul in Betracht gezogen werden. Entsprechend dieser Gestalt lässt sich nun auch eine zentrale Achse sowie eine Innenumfangsfläche und eine Außenumfangsfläche identifizieren. Die Innenumfangsfläche begrenzt dabei insbesondere einen inneren Kanal, durch den das Kühlmedium hindurchströmen kann. Durch diese Anordnung kann der Wirkungsgrad des rohrförmigen thermoelektrischen Moduls deutlich erhöht werden, weil das gasförmige Abgas die großflächige Außenumfangsfläche beaufschlagt und das Kühlmedium durch den inneren Kanal geleitet wird.

Zwischen dieser Innenumfangsfläche und der Außenumfangsfläche sind die thermoelektrischen Materialien positioniert, wobei diese jeweils sogenannten Halbleiterelementen zugeordnet sind. Eine Vielzahl solcher Halbleiterelemente können in Richtung der Achse aufeinander gestapelt angeordnet sein, insbesondere nach der Art, dass abwechselnd ein Halbleiterelement mit p-dotiertem thermoelektrischen Material und ein Halbleiterelement mit n-dotiertem thermoelektrischen Material benachbart zueinander angeordnet sind. Insofern ist ganz besonders bevorzugt, dass sich das Halbleiterelement einer vorgegebenen Dotierung vollständig um die Innenumfangsfläche herum erstreckt, beispielsweise nach Art von Scheiben oder Ringen. Dieses thermoelektrische Material ist nun eingefasst von einem inneren Rahmenteil und/oder einem äußeren Rahmenteil. Bevorzugt ist, dass das Halbleiterelement jeweils ein inneres Rahmenteil sowie ein äußeres Rahmenteil aufweist, die innen und außen jeweils das thermoelektrische Material vollständig umschließen. Entsprechend der Form des Halbleiterelements sind die Rahmenteile beispielsweise nach Art von Ringen bzw. Zylindern ausgeführt.

Besonders bevorzugt ist, dass das thermoelektrische Material mit den Rahmenteilen kraftschlüssig verbunden (verpresst) ist. "Kraftschlüssige Verbindungen" entstehen durch die Übertragung von Kräften. Dazu zählen z. B. Druckkräfte und/oder Reibungskräfte. Der Zusammenhalt der kraftschlüssigen Verbindung wird rein durch die wirkende Kraft gewährleistet.

Weiterhin ist bevorzugt, dass die Rahmenteile gleichzeitig eine Diffusionsbarriere für das thermoelektrische Material sowie einen elektrischen Stromleiter ausbilden. Als Material für die Rahmenteile werden Nickel oder Molybdän bevorzugt, wobei diese jeweils ganz besonders bevorzugt mit zumindest 95 Massenprozent im Werkstoff der Rahmenteile vorhanden sind. Als thermoelektrisches Material werden insbesondere die folgenden Werkstoffe als geeignet angesehen:
n-Typ: Bi₂Te₃; PbTe; Ba_{0,3}Co_{3,95}Ni_{0,05}Sb₁₂; Ba_{y}(Co,Ni)₄Sb₁₂; CoSb₃; Ba₈Ga₁₆Ge₃₀; La₂Te₃; SiGe; Mg₂(Si,Sn);
p-Typ: (Bi,Sb)₂TE₃; Zn₄Sb₃; TAGS; PbTe; SnTe; CeFe₄Sb₁₂; Yb₁₄MnSb₁₁; SiGe; Mg₂(Si,Sb).

Die thermoelektrischen Materialien bzw. die Halbleiterelemente sind nun elektrisch miteinander wechselweise verbunden, so dass sich aufgrund der Temperaturdifferenz zwischen der Innenumfangsfläche und der Außenumfangsfläche ein Stromfluss durch das thermoelektrische Modul und die thermoelektrischen Materialien hindurch ausbildet. Die elektrische Verbindung kann über eine metallische Brücke, ein Kabel, Lotmaterial oder dergleichen realisiert sein. Wie bereits ausgeführt, ist die elektrische Verbindung bevorzugt (nur) mittels des Rahmenteils realisiert.

Bei der erfindungsgemäßen Ausgestaltung des thermoelektrischen Moduls bilden nun zumindest die inneren Rahmenteile keine geschlossene Innenumfangsfläche und/oder gegebenenfalls zusätzlich die äußeren Rahmenteile keine geschlossene Außenumfangsfläche. Damit wird insbesondere zum Ausdruck gebracht, dass zumindest die Innenumfangsfläche und ggf. zusätzlich die Außenumfangsfläche nicht nach Art einer geschlossenen Gehäusewandung ausgeführt, sondern hier Unterbrechungen vorgesehen sind. Für den Fall, dass das thermoelektrische Modul beispielsweise nach Art eines Rohrs ausgebildet ist, wären eine zylindrische geschlossene Innenumfangsfläche und/oder eine zylindrische geschlossene Außenumfangsfläche gegeben. Mit den inneren Rahmenteilen wird nun aber nur ein Teil der zylindrischen Innenumfangsfläche gebildet, so dass ein Teil dieser (gedachten) zylindrischen Innenumfangsfläche frei bzw. unterbrochen ist. Dies gilt ggf. entsprechend für eine (gedachte) zylindrische Außenumfangsfläche, die dann ebenfalls nicht vollständig von den äußeren Rahmenteilen abgebildet wird. Auch wenn das hier für ein rohrähnliches thermoelektrisches Modul veranschaulicht ist, so lässt sich diese Betrachtung entsprechend auf andere Querschnittsformen des thermoelektrischen Moduls sinngemäß übertragen. Diese Unterbrechungen in der Außenumfangsfläche ermöglichen beispielsweise, dass die inneren Rahmenteile von außen auch nach dem Zusammensetzen der Halbleiterelemente für Montage- und/oder Fügeschritte erreichbar sind. Ein weiterer Grund für die hier vorgeschlagenen Unterbrechungen ist, dass das thermoelektrische Modul bzw. die gestapelte und/oder gefügte Anordnung der Halbleiterelemente im Bereich der Außenumfangsfläche bzw. der Innenumfangsfläche in Richtung der Achse nicht starr ist, sondern die Unterbrechungen genutzt werden können, um thermische Dehnungen und/oder Fertigungstoleranzen zu kompensieren. Wird zudem mit jedem (zentral angeordneten) Halbleiterelement ein Verbindungsbereich hin zum benachbarten Halbleiterelement sowohl im Bereich der Innenumfangsfläche als auch im Bereich der Außenumfangsfläche ausgebildet (also beispielsweise an einer Stirnseite über das äußere Rahmenteil und an der anderen Stirnseite über das innere Rahmenteil), kann eine formstabile Konstruktion eines thermoelektrischen Moduls geschaffen werden, ohne dass es hierzu eines weiteren Gehäuses zur Stabilisierung bzw. Abstützung dieser Anordnung bedarf. Insbesondere kann auf ein zusätzliches inneres starres Mantelrohr und/oder ein äußeres starres Mantelrohr verzichtet werden. Hieraus kann sofort erkannt werden, dass diese Anordnung von Halbleiterelementen bzw. die Ausprägung und Verbindung der jeweiligen Rahmenteile technisch einfach durchgeführt werden kann. Zudem kann so eine robuste und für weitere Bearbeitungsschritte sowie den nachfolgenden Einsatz im thermoelektrischen Generator geeignete Anordnung geschaffen werden.

Darüber hinaus wird als vorteilhaft angesehen, dass zumindest an der unterbrochenen Innenumfangsfläche oder ggf. zusätzlich an der unterbrochenen Außenumfangsfläche eine forminstabile Hülle vorgesehen ist. Die Anordnung einer solchen forminstabilen Hülle dient insbesondere dazu, unerwünschte Substanzen davon abzuhalten, in den Zwischenbereich zwischen den thermoelektrischen Materialien bzw. den Halbleiterelementen einzudringen. Gerade für diesen Einsatzzweck können Kunststofffolien, wie beispielsweise ein sogenannter Schrumpfschlauch (an der Außenumfangsfläche), eingesetzt werden. An der Innenumfangsfläche ist insbesondere ein Dehnschlauch vorgesehen, der bei Raumtemperatur eine in Richtung der Außenumfangsfläche gerichtete Vorspannungskraft aufweist. Der Begriff "Dehnschlauch" drückt aus, dass sich die Hülle ohne äußere Krafteinwirkung nach außen ausdehnt. Das heißt, sie weist eine nach außen gerichtete Vorspannungskraft auf. Bei der Anordnung der Hülle auf der Innenumfangsfläche des thermoelektrischen Moduls legt sich die Hülle aufgrund der nach außen gerichteten Vorspannungskraft an den inneren Rahmenteilen an und schützt somit die Halbleiterelemente vor einem Medium, dass die Innenumfangsfläche im Betrieb des thermoelektrischen Moduls überströmt, insbesondere einem Kühlmedium. So ist es beispielsweise möglich, dass die Innenumfangsfläche umströmendes Wasser mittels der forminstabilen Hülle davon abhält, mit dem elektrischen Schaltkreis und/oder dem thermoelektrischen Material im thermoelektrischen Modul in Kontakt zu treten. Der Begriff "forminstabile" Hülle soll dabei insbesondere zum Ausdruck bringen, dass die Stabilität des thermoelektrischen Moduls nur in einem sehr geringen Umfang bzw. nur in einem vernachlässigbaren Umfang durch diese Hülle beeinflusst wird. Diese Stabilität soll über die Verbindungsbereiche der benachbarten Rahmenteile erreicht werden. Ein weiterer Vorteil der forminstabilen Hülle ist, dass sie sich bei thermischer Beanspruchung des thermoelektrischen Moduls elastisch verformen lässt. Somit erzeugt die Hülle keine zusätzlichen Spannungen, die das thermoelektrische Modul belasten könnten. Die Vorspannungskraft bleibt insbesondere bei thermischer Belastung des thermoelektrischen Moduls zumindest teilweise erhalten. Somit erzeugt die Hülle, auch bei thermischer Wechselbeanspruchung des thermoelektrischen Moduls, zu keinem Zeitpunkt im Betrieb eine Zugkraft auf die Halbleiterelemente, bzw. auf die Anordnung der Komponenten im thermoelektrischen Modul. Eine solche Situation ist insbesondere bei Verwendung von starren Rohren als Innenumfangsfläche oder Außenumfangsfläche eines thermoelektrischen Moduls gegeben. Da die starren Rohre jeweils in direktem Kontakt mit z. B. einem Abgas oder einem Kühlmedium stehen, heizen sie sich schneller auf bzw. kühlen sich schneller ab als die übrigen Komponenten des thermoelektrischen Moduls. Somit induzieren die starren Rohre thermische Spannungen in das thermoelektrische Modul, die insbesondere zu einem Versagen der Kontaktierung einzelner Komponenten (Halbleiterelemente, elektrische leitende Brücken, Isolationsschicht) zumindest in radialer Richtung des thermoelektrischen Moduls führen können. Durch die Verwendung von inneren Rahmenteilen und der entsprechend unterbrochenen Innenumfangsfläche wird bei thermischer Wechselbeanspruchung eine unterschiedliche Ausdehnung bzw. Schrumpfung einzelner Komponenten des thermoelektrischen Moduls weitgehend kompensiert. Die forminstabile Hülle induziert darüber hinaus keine weiteren thermischen Spannungen in das thermoelektrische Modul.

Gemäß einer Weiterbildung des thermoelektrischen Moduls wird vorgeschlagen, dass Halbleiterelemente thermoelektrisches Material umfassen, das zwischen einem inneren Rahmenteil und einem äußeren Rahmenteil angeordnet ist, wobei zumindest das innere Rahmenteil und ggf. zusätzlich das äußere Rahmenteil jeweils einseitig über das thermoelektrische Material überstehen und dort einen formsteifen Verbindungsbereich mit einem benachbarten Rahmenteil bilden. Ganz besonders bevorzugt ist in diesem Zusammenhang, dass alle Halbleiterelemente des thermoelektrischen Moduls (mit Ausnahme der Halbleiterelemente am Anfang und am Ende) entsprechende Verbindungsbereiche mit benachbarten Rahmenteilen bilden. Ganz besonders bevorzugt sind dabei stets äußere Rahmenteile mit äußeren Rahmenteilen und innere Rahmenteile mit inneren Rahmenteilen verbunden. Insofern ist es vorteilhaft, wenn die inneren Rahmenteile und die äußeren Rahmenteile bei einem einzelnen Halbleiterelement in verschiedene Richtungen parallel zur Achse überstehen. Hierbei ist möglich, dass dabei jedes Rahmenteil nur hinsichtlich einer Seite des thermoelektrischen Materials übersteht. Bevorzugt ist jedoch, dass zu beiden Seiten des thermoelektrischen Materials jeweils einmal das innere Rahmenteil und einmal das äußere Rahmenteil am weitesten hervorstehen. Ein solcher formsteifer Verbindungsbereich kann beispielsweise mit einer Lotverbindung, einer Klebeverbindung oder einer Schweißverbindung realisiert sein. Die Verbindungsbereiche sind nun insbesondere so ausgelegt (formstabil), dass diese die im Betrieb eines thermoelektrischen Generators im Fahrzeug auftretenden statischen, dynamischen und thermischen Kräfte in Richtung der Achse und/oder radial dazu aufnehmen können. Hierfür ist ganz besonders bevorzugt, dass der Verbindungsbereich sich jeweils über den gesamten Umfang der Rahmenteile erstreckt, beispielsweise als umlaufende Schweißnaht zwischen benachbarten inneren Rahmenteilen sowie ggf. zwischen benachbarten äußeren Rahmenteilen. Diese Verbindungsbereiche gewährleisten nun insbesondere, dass das thermoelektrische Modul formsteif bzw. stabil ist, so dass eine unverlierbare Anordnung der Mehrzahl von Halbleiterelementen gegeben ist. Bei einem solchen thermoelektrischen Modul werden dabei insbesondere mehr als 10, insbesondere mehr als 30 und bevorzugt mehr als 50 solcher Halbleiterelemente gestapelt und wechselseitig mit Verbindungsbereichen ausgeführt. Auch bei solch großen, länglichen thermoelektrischen Modulen kann auf eine stabilisierende zusätzliche Innenwand und/oder zusätzliche Außenwand verzichtet werden, wodurch insbesondere der Fertigungsaufwand reduziert und der Materialaufwand vermindert werden kann.

Einer bevorzugten Ausgestaltung des thermoelektrischen Moduls folgend weist zumindest das innere Rahmenteil oder das äußere Rahmenteil eine Isolationsschicht auf. Diese Isolationsschicht kann bereichsweise und/oder vollständig auf der Oberfläche des inneren Rahmenteils und/oder auf der Oberfläche des äußeren Rahmenteils vorgesehen sein, und dient insbesondere zur elektrischen Isolation der Strompfade. Hierfür kommt insbesondere eine Isolationsschicht umfassend Aluminiumoxid (Al₂O₃) oder dergleichen in Betracht.

Darüber hinaus wird als vorteilhaft angesehen, dass in der unterbrochenen Innenumfangsfläche ein Freiraum zwischen benachbarten inneren Rahmenteilen gebildet ist, der einem Abstand des thermoelektrischen Materials benachbarter Halbleiterelemente entspricht. Hiermit wird insbesondere auch zum Ausdruck gebracht, dass die Anordnung der Halbleiterelemente mit den inneren Rahmenteilen so erfolgt, dass im Bereich der Unterbrechung der Innenumfangsfläche ein möglichst großer Freiraum geschaffen ist und dieser Freiraum insbesondere nicht durch überstehende Bereiche der inneren Rahmenteile eingeschränkt ist.

Dies ermöglicht insbesondere, dass der maximal verfügbare Freiraum hier genutzt werden kann, um beispielsweise die Verbindungsbereiche an den äußeren Rahmenteilen in diesen Freiraum von außen zu verwirklichen. So kann insbesondere mittels einer Schweißvorrichtung eine Schweißnaht zwischen den außen liegenden äußeren Rahmenteilen verwirklicht werden, ohne dass eine zwischen den Halbleiterelementen (im Freiraum) ggf. vorliegende Isolierung durch den Verbindungsprozess beschädigt wird. Im zusammengebauten Zustand wird häufig ein in Umfangsrichtung umlaufender Freiraum gebildet, der definiert wird durch die radial innen liegende Umfangsfläche der benachbarten äußeren Rahmenteile, der sich gegenüberliegenden Oberseite und Unterseite der benachbarten thermoelektrischen Materialien sowie der zugeordneten Unterbrechung der Innenumfangsfläche. Für den Fall, dass ein zylindrisches, rohrförmiges thermoelektrisches Modul vorgegeben ist, hat der Freiraum folglich im Wesentlichen die Form eines Rings, der konzentrisch zur Achse angeordnet ist und sich zwischen benachbarten thermoelektrischen Materialien erstreckt.

Vergleichbare Ausführungen gelten insbesondere auch für die äußeren Rahmenteile, so dass eine Zugänglichkeit von außen zu inneren Rahmenteilen vorliegt. Durch den Freiraum zwischen den Halbleiterelementen kann eine Verbindung zwischen inneren Rahmenteilen hergestellt werden. Dies wird insbesondere dadurch erreicht, dass die äußeren Rahmenteile bündig mit einer Seitenfläche des thermoelektrischen Materials abschließen. Damit sind die benachbarten äußeren Rahmenteile nun so weit voneinander entfernt, wie der Abstand der Oberseite bzw. Unterseite der benachbarten thermoelektrischen Materialien. Im zusammengebauten Zustand wird somit entsprechend ein in Umfangsrichtung umlaufender Freiraum gebildet, der definiert wird durch die radial außen liegende Umfangsfläche der benachbarten inneren Rahmenteile, der sich gegenüberliegenden Oberseite und Unterseite der benachbarten thermoelektrischen Materialien sowie der zugeordneten Unterbrechung der Außenumfangsfläche.

Gemäß einer Weiterbildung ist zumindest in der unterbrochenen Innenumfangsfläche ein Freiraum zwischen benachbarten inneren Rahmenteilen gebildet, der mit einem porösen Isolationsmaterial gefüllt ist. Das bedeutet insbesondere, dass der von radial innen zugängliche Freiraum zwischen benachbarten thermoelektrischen Materialien nicht (ausschließlich) mit Luft gefüllt ist, sondern dass hier (zusätzlich) ein poröses Isolationsmaterial vorgesehen ist. Das Material dient nun insbesondere dazu, eine elektrische Isolierung im Übergangsbereich zwischen benachbarten Halbleiterelementen zu realisieren. Ebenso kann das Isolationsmaterial dazu dienen, einen signifikanten Temperaturausgleich zwischen der Innenumfangsfläche und der Außenumfangsfläche im Bereich des Freiraums zu reduzieren oder zu verhindern. Die poröse Ausgestaltung des Isolationsmaterials führt insbesondere dazu, dass dieses sehr leicht ist und gleichwohl einen hohen Anteil von Luft als thermischen Isolator aufweisen kann. Als ein solches poröses Isolationsmaterial kommt insbesondere ein hochporöser Festkörper in Betracht, bei dem beispielsweise mindestens 95 % oder sogar mindestens 99 % des Volumens aus Poren besteht. Das Isolationsmaterial weist dabei bevorzugt eine stark dendritische Struktur auf, also eine Verästelung von Partikelketten mit sehr vielen Zwischenräumen in Form von offenen Poren, so dass insbesondere eine relativ stabile, schwammartige Netzstruktur gebildet ist. Ganz besonders bevorzugt ist hier der Einsatz eines sogenannten Aerogels, beispielsweise auf Basis eines Silikats. Das poröse Isolationsmaterial kann ggf. zusätzlich auch im, zwischen benachbarten äußeren Rahmenteilen gebildeten, Freiraum angeordnet sein.

Darüber hinaus wird als vorteilhaft angesehen, dass die zumindest an der Innenumfangsfläche vorgesehene forminstabile Hülle ein Dehnschlauch ist, der bei Raumtemperatur eine in Richtung hin zur Außenumfangsfläche gerichtete Vorspannungskraft aufweist.

Gemäß einer vorteilhaften Weiterentwicklung weist die forminstabile Hülle/der Dehnschlauch mindestens ein Federelement auf, das die Vorspannungskraft erzeugt. Das Federelement ist insbesondere ein Federring, der mit der forminstabilen Hülle verbunden ist. Dieser Federring wird zur Montage der instabilen Hülle zusammengedrückt und in den inneren Kanal eingeschoben. Die Federwirkung des mindestens einen Federringes fixiert die forminstabile Hülle auf der Innenumfangsfläche des thermoelektrischen Moduls. Insbesondere liegt der mindestens eine Federring zumindest teilweise an den inneren Rahmenteilen auf, und ist nicht ausschließlich im Bereich des Freiraums angeordnet. Eine derartige Anordnung (Federring liegt ausschließlich im Bereich des Freiraums auf) kann aber insbesondere dann vorteilhaft sein, wenn im Freiraum ein (nicht gasförmiges) Isolationsmaterial angeordnet ist.

Gemäß einer besonders vorteilhaften Ausgestaltung besteht die forminstabile Hülle zumindest teilweise zumindest teilweise aus mindestens einem der folgenden Materialien: Formgedächtnislegierung (shape memory alloy - SMA), Formgedächtnis-Polymer (shape memory polymer - SMP).

Die forminstabile Hülle (oder auch der Dehnschlauch) kann somit an der Innenumfangsfläche angeordnet und z. B. durch eine Erwärmung in ihre ursprüngliche Form umgewandelt werden. Diese ursprüngliche Form ist bevorzugt größer als die Innenumfangsfläche des thermoelektrischen Moduls, so dass nach der Umwandlung eine nach radial außen gerichtete Vorspannungskraft an der Innenumfangsfläche erzeugt wird. Formgedächtnis-Werkstoffe zeichnen sich dadurch aus, dass sie sich trotz einer nachfolgenden starken Verformung an eine ursprüngliche Form "erinnern" können. Hier sind insbesondere Werkstoffe als forminstabile Hülle bevorzugt, die einen sogenannten Einweg-(Memory-)Effekt aufweisen. Dieser Effekt beinhaltet eine einmalige Formänderung z. B. beim Aufheizen. Eine Formrückkehr ist hier nicht möglich. Dadurch kann sichergestellt werden, dass die forminstabile Hülle nach erfolgter Anordnung an der Innenumfangsfläche dauerhaft positioniert ist. Als Formgedächtnislegierung ist zumindest einer der folgenden Werkstoffe geeignet: Nickel-Titan, Kupfer-Zink, Kupfer-Zink-Aluminium, Kupfer-Aluminium-Nickel und/oder Eisen-Nickel-Aluminium-Legierungen. Ein Formgedächtnis-Polymer umfasst z. B. ein Thermoplast, ein warmhärtendes Material, sich gegenseitig durchdringende Netze, sich gegenseitig halb durchdringende Netze und/oder vermischte Netze. Das Polymer kann ein einzelnes Polymer oder eine Mischung von Polymeren sein. Polymere können geradkettige oder verzweigtkettige thermoplastische Elastomere mit Seitenketten oder dentritischen Strukturelementen sein. Geeignete Polymerkomponenten zur Bildung eines Formgedächtnispolymers umfassen z. B. Polyphosphazene, Polyvinylalkohole, Polyamide, Polyesteramide, Polyaminosäuren, Polyanhydride, Polycarbonate, Polyacrylate, Polyalkylene, Polyacrylamide, Polyalkylenglycole, Polyalkylenoxide, Polyalkylenterepthalate, Polyorthoester, Polyvinylether, Polyvinylester, Polyvinylhologenide, Polyester, Polylactide, Polyglycolide, Polysiloxane, Polyurethane, Polyether, Polyetheramide, Polyetherester und Copolymere hiervon. Gegebenenfalls können die Materialien auch miteinander kombiniert werden, um eine forminstabile Hülle zu bilden, wobei ggf. Verbindungselemente separate Teile (z. B. Ringe) aus unterschiedlichen Materialien (flexibel) zusammen halten. Die Anordnung der Materialien in der forminstabilen Hülle kann insbesondere unter Berücksichtigung der Temperaturbeanspruchung im Betrieb vorgenommen sein.

Insbesondere beträgt bei Raumtemperatur (20 °C) die Vorspannungskraft der forminstabilen Hülle/des Dehnschlauchs an den inneren Rahmenteilen mindestens 15 N/mm² [Newton pro Quadratmillimeter], insbesondere mindestens 20 N/mm². Gemäß einer vorteilhaften Ausgestaltung, beträgt bei einer Temperatur zwischen 150 °C und 250 °C an der forminstabilen Hülle die Vorspannungskraft an den inneren Rahmenteilen mindestens 10 N/mm², bevorzugt mindestens 15 N/mm².

Zudem wird es als vorteilhaft angesehen, zwischen der forminstabilen Hülle und der Innenumfangsfläche und ggf. zusätzlich zwischen der forminstabilen Hülle und der Außenumfangsfläche einen Kleber anzuordnen. Insbesondere wird dieser Kleber zwischen der forminstabilen Hülle und dem die Innenumfangsfläche bildenden inneren Rahmenteil angeordnet. Somit kann an der sogenannten Kaltseite des thermoelektrischen Moduls ein entsprechender Kleber eingesetzt werden, der eine "geringe" Temperaturbeständigkeit von mindestens 150°C, insbesondere mindestens 200°C, aufweist. Dabei beträgt die maximale Temperaturbeständigkeit insbesondere 250°C. Der Kleber ist insbesondere thermisch leitfähig, so dass der Wärmestrom über das thermoelektrische Modul nur in geringem Maße beeinflusst wird.

Darüber hinaus wird als vorteilhaft angesehen, dass das thermoelektrische Material der Halbleiterelemente wenigstens teilweise mit einer Beschichtung versehen ist. Eine solche Beschichtung dient insbesondere dazu, dauerhaft die Zusammensetzung bzw. Konstitution des thermoelektrischen Materials zu gewährleisten. Die Beschichtung ist insbesondere vollflächig auf den Seitenflächen bzw. der Oberseite und/oder der Unterseite des thermoelektrischen Materials vorgesehen, so dass ganz besonders bevorzugt das thermoelektrische Material komplett eingefasst ist von einem inneren Rahmenteil, einem äußeren Rahmenteil und dieser Beschichtung.

Die Erfindung findet insbesondere Anwendungen bei Fahrzeugen, insbesonderte Kraftfahrzeugen. Folglich wird ein Kraftfahrzeug mit einer Verbrennungskraftmaschine, einem Abgassystem und einem Kühlsystem vorgeschlagen, wobei ein thermoelektrischer Generator vorgesehen ist, der eine Mehrzahl der hier erfindungsgemäß beschriebenen Module aufweist, wobei sich das Abgassystem außen entlang der Außenumfangsfläche des thermoelektrischen Moduls und das Kühlsystem durch die Innenumfangsfläche des thermoelektrischen Moduls hindurch erstreckt. Das heißt mit anderen Worten auch, dass beispielsweise das Kühlmittel des Kühlmittelsystems innen durch einen Kanal, der durch die Innenumfangsfläche der thermoelektrischen Module begrenzt ist, hindurchströmt, so dass die Innenumfangsfläche des thermoelektrischen Moduls die Kaltseite darstellt. Ebenso bedeutet das, dass das heiße Abgas außen entlang der Außenumfangsfläche der thermoelektrischen Module vorbeigeführt wird, so dass die Außenumfangsfläche dann die Heißseite darstellt. Besonders bevorzugt ist, dass der thermoelektrische Generator dabei nach Art eines Rohrbündels aufgebaut ist, wobei einerseits eine Vielzahl dieser thermoelektrischen Module dann an das Kühlsystem angeschlossen ist, so dass diese von einem Kühlmittelstrom durchströmt werden, und andererseits die thermoelektrischen Module beispielsweise in einem gemeinsamen (beabstandeten) Gehäuse angeordnet sind, so dass diese gemeinsam von einem Abgas umströmt werden können. Selbstverständlich sind entsprechende elektrische Anschlüsse und Leitungen vorzusehen, um eine sichere Stromerzeugung und Weiterleitung des Stroms, des Kühlmittels und des Abgases zu realisieren.

Die Erfindung sowie der Stand der Technik werden nachfolgend anhand der Figuren näher erläutert. Es ist darauf hinzuweisen, dass die in den Figuren gezeigten Ausführungsbeispiele bevorzugt sind, die Erfindung jedoch nicht darauf beschränkt ist. Die Figuren zeigen schematisch:
- Fig. 1:: eine Anordnung mehrerer Halbleiterelemente zu einem thermoelektrischen Modul,
- Fig. 2:: einen Querschnitt durch eine Ausführungsvariante eines thermoelektrischen Moduls,
- Fig. 3:: einen Querschnitt durch eine weitere Ausführungsvariante eines Halbleiterelements, und
- Fig. 4:: ein Schema für ein Fahrzeug mit einem thermoelektrischen Generator.

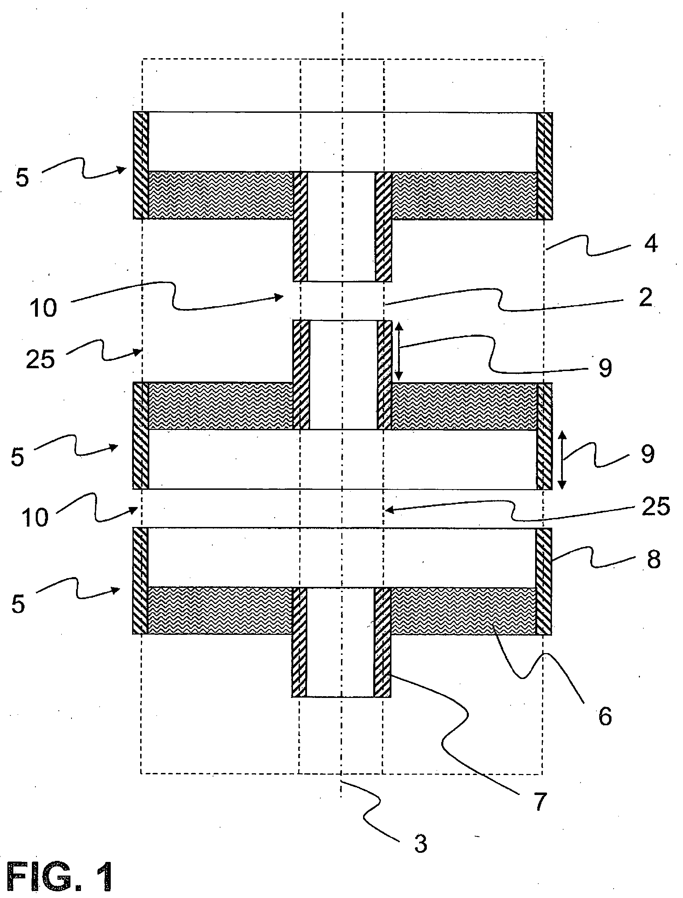

In Fig. 1 ist schematisch veranschaulicht, wie eine Mehrzahl von Halbleiterelementen 5 zusammengesetzt werden kann, um ein thermoelektrisches Modul mit den erfindungsgemäß angeführten Eigenschaften herzustellen. Zunächst ist hierbei festzuhalten, dass alle Halbleiterelemente 5 im Wesentlichen identisch ausgeführt sind, insbesondere was die Anordnung bzw. Abmaße des äußeren Rahmenteils 8, des thermoelektrischen Materials 6 und des inneren Rahmenteils 7 betrifft. Die entsprechende Verbindung bzw. der gewünschte Aufbau des thermoelektrischen Elements wird nun dadurch realisiert, dass die Halbleiterelemente 5 in Richtung der Achse 3 mit entgegengesetzten Orientierungen abwechselnd zueinander angeordnet sind. Damit wird nun erreicht, dass die benachbarten Halbleiterelemente 5 entweder (nur) mit den inneren Rahmenteilen 7 oder den äußeren Rahmenteilen 8 miteinander beim Stapelvorgang in Kontakt kommen. Dabei ist ganz besonders bevorzugt, dass die thermoelektrischen Materialien 6 aller Halbleiterelemente 5, die in eine erste Richtung entlang der Achse 3 ausgerichtet sind, dieselbe Dotierung aufweisen (z. B. n-dotiert). Die jeweils dazwischen angeordneten, in eine zweite, entgegengesetzte Richtung entlang der Achse 3 ausgerichteten Halbleiterelemente 5 weisen eine andere Dotierung auf (z. B. p-dotiert).

Bei der hier aufgezeigten Ausführungsvariante sind die Halbleiterelemente 5 nach Art von ringförmigen Scheiben ausgeführt, wobei insbesondere das thermoelektrische Material 6 nach Art einer Kreisringscheibe ausgeführt ist. Die radial innenliegende Umfangsfläche und außenliegende Umfangsfläche des thermoelektrischen Materials 6 ist jeweils von dem (einstückigen) äußeren Rahmenteil 8 bzw. dem (einstückigen) inneren Rahmenteil 7 bedeckt. Die Halbleiterelemente 5 sind weiter so gestaltet, dass die äußeren Rahmenteile 8 einen Überstand 9 auf einer Seite des thermoelektrischen Materials 6 ausbilden, während die inneren Rahmenteile 7 auf der gegenüberliegenden Seite einen Überstand 9 über das thermoelektrische Material 6 ausbilden. Diese Ausgestaltung zusammen mit der wechselweise entgegengesetzten Orientierung dieser Überstände erlaubt es nun, dass benachbarte Halbleiterelemente 5 über die inneren Rahmenteile 7 Verbindungsbereiche 10 ausbilden sowie über benachbarte äußere Rahmenteile 8. Dabei bilden die Überstände 9 eine Art ringförmigen Kragen aus, die stirnseitig (auf Stoß) zusammengesetzt werden können. Dieser Stoßbereich dient insbesondere zur Ausbildung von stoffschlüssigen Verbindungen (Stoffschlüssige Verbindungen werden Verbindungen genannt, bei denen die Verbindungspartner durch atomare und/oder molekulare Kräfte zusammengehalten werden, wie beispielsweise beim Kleben, Löten, Schweißen, etc.), insbesondere umlaufenden Schweißnähten.

Darüber hinaus ist bereits aus Fig. 1 zu erkennen, dass die so zusammengesetzten Halbleiterelemente 5 keine geschlossene Innenumfangsfläche 2 und keine geschlossene Außenumfangsfläche 4 bilden. Dies lässt sich insbesondere dadurch erkennen, dass in einem Querschnitt, in dem ein Verbindungsbereich 10 der inneren Rahmenteile 7 realisiert ist, außen kein äußeres Rahmenteil 8 vorgesehen ist und umgekehrt. Damit ist insbesondere auch gemeint, dass ein (einzelnes) äußeres Rahmenteil 8 nicht gleichzeitig mit beiden benachbarten äußeren Rahmenteilen 8 der benachbarten Halbleiterelemente 5 in Kontakt kommt. Ebenso gilt, dass ein (einzelnes) inneres Rahmenteil 7 eines Halbleiterelements 5 nicht mit beiden Rahmenteilen 7, 8 von benachbarten Halbleiterelementen 5 in Kontakt ist. Somit füllen die äußeren Rahmenteile 8 nicht vollständig die äußere (gedachte) Außenumfangsfläche 4 aus, ebenso füllen die inneren Rahmenteile 7 nicht die gesamte Innenumfangsfläche 2 aus. Vielmehr sind in beiden Fällen Unterbrechungen 25 gebildet. Hierbei wird insbesondere von der Vorstellung ausgegangen, dass sich die Innenumfangsfläche 2 und die Außenumfangsfläche 4 durch Umfangsflächenabschnitte beschreiben lässt, die im Wesentlichen dieselbe Distanz zur Achse 3 aufweisen. Handelt es sich beispielsweise um ein zylindrisches, rohrähnliches thermoelektrisches Modul, so sind die äußeren Rahmenteile 8 und die inneren Rahmenteile 7 beispielsweise ebenfalls zylindrisch gebildet, so dass folglich auch zylindrische Innenumfangsflächen 2 und Außenumfangsflächen 4 gebildet sind, die sich durch die jeweiligen äußeren Rahmenteile 8 und inneren Rahmenteile 7 hindurch erstrecken. Entsprechende Überlegungen können beispielsweise angestellt werden, wenn die Rahmenteile eine elliptische oder polygonale Umfangsfläche bilden, demnach hat das thermoelektrische Modul dann insgesamt auch eine elliptische oder polygonale Innenumfangsfläche/Außenumfangsfläche, in der jeweils die entsprechenden Umfangsabschnitte der äußeren Rahmenteile und inneren Rahmenteile aufgenommen sind. Erfindungsgemäß ist dann insbesondere, wenn die äußeren Rahmenteile 8 und inneren Rahmenteile 7 keine geschlossene, sondern eine unterbrochene, also nicht vollständig ausgefüllte, Innenumfangsfläche/Außenumfangsfläche bilden.

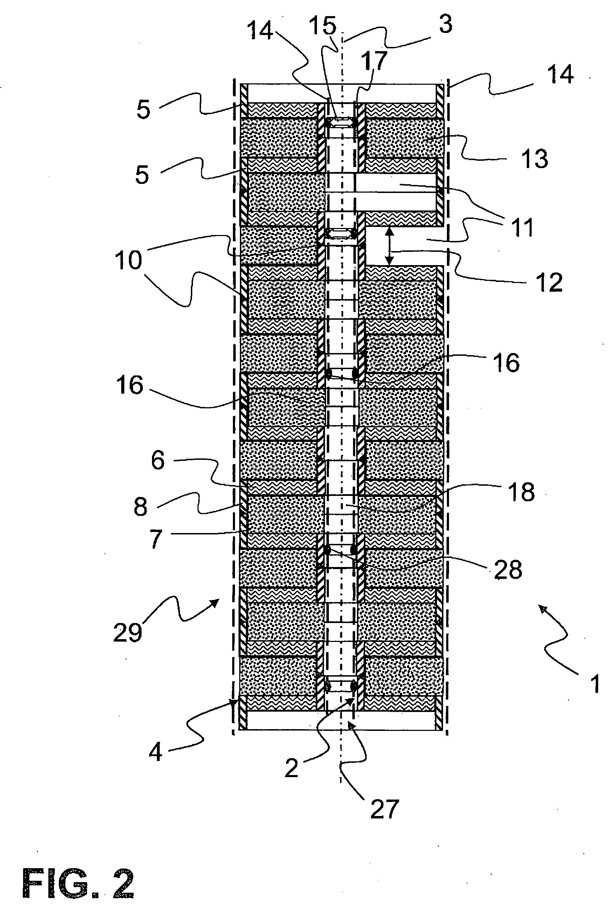

Fig. 2 zeigt nun eine zusammengesetzte Ausführungsvariante eines thermoelektrischen Moduls 1. Dabei sind nun die Halbleiterelemente 5 auf Stoß wechselweise entlang der Achse 3 angeordnet und miteinander befestigt. Die wechselweise Anordnung von Halbleiterelementen 5 erfolgt in der Art, dass die inneren Rahmenteile 7 aneinander anliegen und einen Verbindungsbereich 10 (z. B. eine Schweißnaht) ausbilden, so dass benachbart hierzu ein Freiraum 11 gebildet ist, der sich radial auswärts bis hin zur Außenumfangsfläche 4 erstreckt. Gleiches gilt für den Freiraum 11, der sich von aneinander anliegenden äußeren Rahmenteilen 8 nach radial innen erstreckt. Die Freiräume 11 sind nun so gestaltet, dass diese einem Abstand 12 der thermoelektrischen Materialien 6 benachbarter Halbleiterelemente 5 entsprechen. Zur Veranschaulichung wurde deshalb im oberen rechten Bereich der Fig. 2 ein Element (Isolationsmaterial 13) nicht dargestellt, das jedoch tatsächlich für den Betrieb vorgesehen ist.

Darüber hinaus ist hier zu erkennen, dass an der unterbrochenen Innenumfangsfläche 2 und auch an der unterbrochenen Außenumfangsfläche 4 eine forminstabile Hülle 14 vorgesehen ist. Die Hülle 14 an der Innenumfangsfläche 2 kann beispielsweise nach der Anordnung bzw. Präparation der Bauteile des thermoelektrischen Moduls 1 in den Kanal 18 innerhalb der Halbleiterelemente 5 eingeschoben werden. Hierfür bietet sich insbesondere eine Kunststofffolie an, beispielsweise ein Dehnschlauch, der Federelemente 16 (z. B. Federring) aufweist. Durch die Federelemente 16 wirkt eine Vorspannungskraft 15 gegen die Innenumfangsfläche 2. Dieser Dehnschlauch bzw. diese forminstabile Hülle 14 gewährleistet nun, dass kein Wasser in Bereiche innerhalb der Innenumfangsfläche 2 eindringen kann. Gleichermaßen ist eine gute Wärmeleitung bzw. Kühlung hin zu den Halbleiterelementen 5 bzw. inneren Rahmenteilen 7 gewährleistet. Hierfür ist die Hülle 14 entsprechend dünn auszuführen. Die Federelemente 16 bilden dabei Erhebungen 28, die eine Durchmischung des Kühlmittels bewirken und laminare Randströmungen vermeiden und somit den Wirkungsgrad des thermoelektrischen Moduls 1 erhöhen können. Die Federelemente 16 sind hier so angeordnet, dass sie an einem inneren Rahmenteil 7 anliegen. Zwischen der forminstabilen Hülle 14 und den inneren Rahmenteilen 7 ist ein Kleber 17 angeordnet, so dass insbesondere eine dichtende Verbindung zwischen inneren Rahmenteilen 7 und der forminstabilen Hülle 14 erreicht wird. Insbesondere ist der Kleber 17 nur an den jeweiligen Enden des thermoelektrischen Moduls 1 zwischen der forminstabilen Hülle 14 und den inneren Rahmenteilen 7 angeordnet, so dass hier eine dichtende Verbindung gegenüber z. B. einem Kühlsystem erreicht wird. Das Kühlmittel durchströmt das thermoelektrische Modul 1 hier durch den Kanal 18. Entsprechend bildet die Innenumfangsfläche 2 die Kaltseite 27. Die Außenumfangsfläche 4 des thermoelektrischen Moduls 1 wird hier von dem Abgas überströmt und bildet entsprechend die Heißseite 29.

Im Bereich der offenen Freiräume 11 ist nun zudem ein poröses Isolationsmaterial 13 vorgesehen. Hierbei handelt es sich insbesondere um ein sogenanntes Aerogel. Dadurch ist einerseits der gewünscht große Temperaturgradient und zum anderen die elektrische Neutralität des Freiraums 11 gewährleistet. Hierbei ist bevorzugt, dass das poröse Isolationsmaterial 13 den gesamten Freiraum 11 ausfüllt.

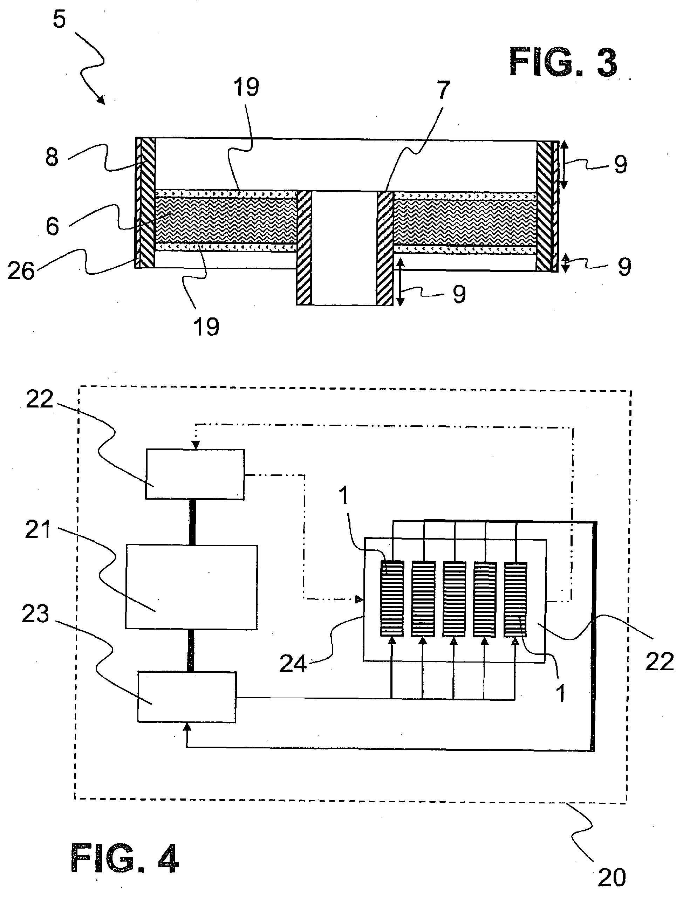

Fig. 3 zeigt den Querschnitt einer Ausführungsvariante eines Halbleiterelements 5 für ein solches thermoelektrisches Modul. Hierbei ist das Halbleiterelement 5 beispielsweise zylindrisch, viereckig oder oval ausgeführt. Bei der hier vorgestellten Ausführungsvariante ist wieder ein im Wesentlichen ringförmig ausgebildetes thermoelektrisches Material 6 vorgesehen, das beispielsweise aus gepresstem Pulver besteht. Ebenso ist bevorzugt, dass dieses thermoelektrische Material 6 durch Pressen kraftschlüssig (und/oder stoffschlüssig) mit dem inneren Rahmenteil 7 und/oder dem äußeren Rahmenteil 8 verbunden ist. Hierbei ist nun vorgesehen, dass nach oben hin ein großer Überstand 9 mit dem äußeren Rahmenteil 8 und nach unten ein kleiner Überstand 9 mit dem äußeren Rahmenteil 8 und ein großer Überstand 9 mit dem inneren Rahmenteil 7 ausgebildet ist. Auf diese Weise können die Kontaktbereiche bzw. Freiräume hin zu benachbarten Halbleiterelementen bei der Anordnung zu einem thermoelektrischen Modul wunschgemäß ausgebildet werden. Zum Schutz des thermoelektrischen Materials 6, z. B. vor einer chemischen Beanspruchung, vor einer thermischen Beanspruchung und/oder vor einer Beschädigung, weist das thermoelektrische Material 6 an den Grenzflächen, an denen es nicht mit dem inneren Rahmenteil 7 oder dem äußeren Rahmenteil 8 bedeckt ist, eine Beschichtung 19 auf. Die Beschichtung 19 hat dabei eine Dicke, die mindestens um ein Vielfaches kleiner ausgeführt ist als die Wandstärke des äußeren Rahmenteils 8, des inneren Rahmenteils 7 und/oder des thermoelektrischen Materials 6 selbst. Als Material für diese Beschichtung 19 kommt beispielsweise eine Nickel oder Molybdän aufweisende, insbesondere aus diesen Materialien nahezu vollständig bestehende Beschichtung 19 in Betracht. Die Beschichtung 19 dient hierbei als Diffusionssperre für das thermoelektrische Material 6. Auf dem äußeren Rahmenteil 8 ist zudem eine Isolationsschicht 26 gezeigt, die das elektrisch leitende Rahmenteil 8 nach radial außen elektrisch isoliert, z. B. gegenüber einem später dort angeordneten Außenrohr.

Schließlich ist in Fig. 4 schematisch noch der Aufbau eines Fahrzeuges 20 veranschaulicht, das eine Verbrennungskraftmaschine 21, ein Abgassystem 22 und ein Kühlsystem 23 hat. Zudem weist das Fahrzeug 20 einen thermoelektrischen Generator 24 auf, der in eine Mehrzahl der hier erfindungsgemäß vorgestellten thermoelektrischen Module 1 aufweist. Der thermoelektrische Generator 24 ist so mit dem Abgassystem 22 und dem Kühlsystem 23 ausgebildet, dass auf der Außenumfangsfläche 4 der Module 1 die Heißseite und auf der Innenumfangsfläche 2 des thermoelektrischen Moduls 1 die Kaltseite realisiert ist. Dazu wird zumindest ein Teil des Abgases so zu dem thermoelektrischen Generator 24 geführt, dass das Abgas außen die thermoelektrischen Module 1 umströmt, bevor es dem Abgassystem 22 (oder der Verbrennungskraftmaschine 21) wieder zugeführt wird. Zur Ausbildung des erforderlichen Temperaturprofils hinsichtlich der thermoelektrischen Module 1 wird zudem Kühlmittel mittels des Kühlsystems 23 durch die einzelnen thermoelektrischen Module 1 hindurchgeführt und schließlich dem Kühlsystem 23 (oder der Verbrennungskraftmaschine 21) wieder zugeführt. Selbstverständlich ist möglich, dass das Kühlsystem 23 und/oder das Abgassystem 22 mit Sekundär-Schaltkreisen für Abgas und/oder Kühlmittel ausgeführt sind. Ebenso ist möglich, dass beispielsweise in dem Abgassystem zusätzliche Wärmetauscher, Klappen, Katalysatoren, etc. vorgesehen sind. Ebenso ist offensichtlich, dass der thermoelektrische Generator 24 auch elektrisch mit dem Fahrzeug 20 in Verbindung steht, beispielsweise über geeignete Stromabnehmer, Stromspeicher, Steuerungen, etc.

Damit löst die Erfindung die mit Bezug auf den Stand der Technik geschilderten Probleme zumindest teilweise. Insbesondere wurde ein thermoelektrisches Modul angegeben, das technisch einfach herstellbar ist, eine reduzierte Teilezahl aufweist, für den gewünschten Einsatz stabil ist und zudem einen hohen Wirkungsgrad aufweist, um der thermischen Energie eines Abgases elektrische Energie zu erzeugen.

### Bezugszeichenliste

- 1: thermoelektrisches Modul
- 2: Innenumfangsfläche
- 3: Achse
- 4: Außenumfangsfläche
- 5: Halbleiterelement
- 6: thermoelektrisches Material
- 7: inneres Rahmenteil
- 8: äußeres Rahmenteil
- 9: Überstand
- 10: Verbindungsbereich
- 11: Freiraum
- 12: Abstand
- 13: Isolationsmaterial
- 14: Hülle
- 15: Vorspannungskraft
- 16: Federelement
- 17: Kleber
- 18: Kanal
- 19: Beschichtung
- 20: Fahrzeug
- 21: Verbrennungskraftmaschine
- 22: Abgassystem
- 23: Kühlsystem
- 24: thermoelektrischer Generator
- 25: Unterbrechung
- 26: Isolationsschicht
- 27: Kaltseite
- 28: Erhebung
- 29: Heißseite

## Patentansprüche

1. Thermoelektrisches Modul (1), aufweisend eine Innenumfangsfläche (2), eine Achse (3) und eine Außenumfangsfläche (4), wobei in Richtung der Achse (3) und zwischen der Innenumfangsfläche (2) und der Außenumfangsfläche (4) eine Mehrzahl von Halbleiterelementen (5) mit thermoelektrischem Material (6) angeordnet und elektrisch miteinander wechselweise verbunden ist, wobei wenigstens ein Teil der Halbleiterelemente (5) zumindest ein inneres Rahmenteil (7) aufweist, so dass die inneren Rahmenteile (7) eine unterbrochene Innenumfangsfläche (2) bilden, wobei weiter die. Innenumfangsfläche (2) eine Kaltseite (2 7) des thermoelektrischen Moduls (1) bildet **dadurch gekennzeichnet dass** zumindest an der unterbrochenen Innenumfangsfläche (2) eine forminstabile Hülle (14) vorgesehen ist.

2. Thermoelektrisches Modul (1) nach Patentanspruch 1, bei dem Halbleiterelemente (5) thermoelektrisches Material (6) umfassen, das zwischen einem inneren Rahmenteil (7) und einem äußeren Rahmenteil (8) angeordnet ist, wobei zumindest das innere Rahmenteil (7) einseitig über das thermoelektrische Material (6) übersteht und dort einen formsteifen Verbindungsbereich (10) mit einem benachbarten Rahmenteil bildet.

3. Thermoelektrisches Modul (1) nach einem der vorhergehenden Patentansprüche, wobei zumindest in der unterbrochenen Innenumfangsfläche (2) ein Freiraum (11) zwischen benachbarten inneren Rahmenteilen (7) gebildet ist, der mit einem porösen Isolationsmaterial (13) gefüllt ist.

4. Thermoelektrisches Modul (1) nach einem der vorhergehenden Patentansprüche, wobei die zumindest an der Innenumfangsfläche (2) vorgesehene forminstabile Hülle (14) ein Dehnschlauch ist, der bei Raumtemperatur eine in Richtung hin zur Außenumfangsfläche (4) gerichtete Vorspannungskraft (15) aufweist.

5. Thermoelektrisches Modul (1) nach Patentanspruch 4, wobei die forminstabile Hülle (14) mindestens ein Federelement (16) aufweist, das die Vorspannungskraft (15) erzeugt.

6. Thermoelektrisches Modul (1) nach Patentanspruch 4 oder 5, wobei die forminstabile Hülle (14) zumindest teilweise aus mindestens einem der folgenden Materialien besteht: Formgedächtnislegierung (shape memory alloy - SMA), Formgedächtnis-Polymer (shape memory polymer - SMP).

7. Thermoelektrisches Modul (1) nach einem der Patentansprüche 4 bis 6, wobei bei Raumtemperatur die Vorspannungskraft (15) an den inneren Rahmenteilen (7) zumindest 15 N/mm² beträgt.

8. Thermoelektrisches Modul (1) nach einem der Patentansprüche 4 bis 7, wobei bei einer Temperatur zwischen 150 °C und 250 °C an der forminstabilen Hülle (14) die Vorspannungskraft (15) an den inneren Rahmenteilen (7) mindestens 10 N/mm² beträgt.

9. Thermoelektrisches Modul (1) nach einem der vorhergehenden Patentansprüche, wobei zwischen der forminstabilen Hülle (14) und zumindest der Innenumfangsfläche (2) ein Kleber (17) angeordnet ist.

10. Fahrzeug (20) mit einer Verbrennungskraftmaschine (21), einem Abgassystem (22) und einem Kühlsystem (23), wobei ein thermoelektrischer Generator (24) vorgesehen ist, der eine Mehrzahl von thermoelektrischen Modulen (1) gemäß einem der vorhergehenden Patentansprüche aufweist, wobei sich das Abgassystem (22) außen entlang der Außenumfangsfläche (4) des thermoelektrischen Moduls (1) und das Kühlsystem (23) sich innerhalb und entlang der Innenumfangsfläche (2) des thermoelektrischen Moduls (1) hindurch erstreckt.

## Claims

1. Thermoelectric module (1), having an inner circumferential surface (2), an axis (3) and an outer circumferential surface (4), wherein a plurality of semiconductor elements (5) containing thermoelectric material (6) is arranged in the direction of the axis (3) and between the inner circumferential surface (2) and the outer circumferential surface (4) and connected electrically to one another in alternation, wherein at least some of the semiconductor elements (5) have at least an inner frame part (7), with the result that the inner frame parts (7) form an interrupted inner circumferential surface (2), wherein the inner circumferential surface (2) furthermore forms a cold side (27) of the thermoelectric module (1), **characterized in that** a dimensionally unstable sheath (14) is provided at least at the interrupted inner circumferential surface (2).

2. Thermoelectric module (1) according to Patent Claim 1, in which semiconductor elements (5) contain thermoelectric material (6) which is arranged between an inner frame part (7) and an outer frame part (8), wherein at least the inner frame part (7) projects on one side beyond the thermoelectric material (6) and there forms a dimensionally rigid connecting region (10) with an adjacent frame part.

3. Thermoelectric module (1) according to one of the preceding patent claims, wherein a free space (11) is formed between adjacent inner frame parts (7), at least in the interrupted inner circumferential surface (2), said free space being filled with a porous insulating material (13).

4. Thermoelectric module (1) according to one of the preceding patent claims, wherein the dimensionally unstable sheath (14) provided at least at the inner circumferential surface (2) is an expansion hose which has a preloading force (15) directed toward the outer circumferential surface (4) at room temperature.

5. Thermoelectric module (1) according to Patent Claim 4, wherein the dimensionally unstable sheath (14) has at least one spring element (16), which produces the preloading force (15).

6. Thermoelectric module (1) according to Patent Claim 4 or 5, wherein the dimensionally unstable sheath (14) is composed at least partially of at least one of the following materials: shape memory alloy (SMA) or shape memory polymer (SMP).

7. Thermoelectric module (1) according to one of Patent Claims 4 to 6, wherein the preloading force (15) on the inner frame parts (7) is at least 15 N/mm² at room temperature.

8. Thermoelectric module (1) according to one of Patent Claims 4 to 7, wherein the preloading force (15) on the inner frame parts (7) is at least 10 N/mm² at a temperature of between 150° C and 250° C at the dimensionally unstable sheath (14).

9. Thermoelectric module (1) according to one of the preceding patent claims, wherein an adhesive (17) is arranged between the dimensionally unstable sheath (14) and at least the inner circumferential surface (2).

10. Vehicle (20) having an internal combustion engine (21), an exhaust system (22) and a cooling system (23), wherein a thermoelectric generator (24) is provided which has a plurality of thermoelectric modules (1) as per one of the preceding patent claims, wherein the exhaust system (22) extends externally along the outer circumferential surface (4) of the thermoelectric module (1), and the cooling system (23) extends within and along the inner circumferential surface (2) of the thermoelectric module (1).

## Revendications

1. Module (1) thermoélectrique ayant une surface (2) périphérique intérieure, un axe (3) et une surface (4) périphérique extérieure, dans lequel une pluralité d'éléments (5) à semiconducteur ayant de la matière (6) thermoélectrique sont montés dans la direction de l'axe (3) et entre la surface (2) périphérique intérieure et la surface (4) périphérique extérieure et sont reliés électriquement à tour de rôle entre eux, au moins une partie des éléments (5) à semiconducteur ayant au moins une partie (7) intérieure de cadre de manière à ce que les parties (7) intérieures de cadre forment une surface (2) périphérique intérieure interrompue, dans lequel, en outre, la surface (2) périphérique intérieure forme un côté (27) froid du module (1) thermoélectrique, **caractérisé en ce qu'**il est prévu un manchon (14) de forme instable au moins à la surface (2) périphérique intérieure interrompue.

2. Module (1) thermoélectrique suivant la revendication 1, dans lequel des éléments (5) à semiconducteur comprennent de la matière (6) thermoélectrique, qui est disposée entre une partie (7) intérieure de cadre et une partie (8) extérieure de cadre, au moins la partie (7) de cadre dépassant d'un côté de la matière (6) thermoélectrique et y formant une région (10) de liaison de forme rigide avec une partie de cadre voisine.

3. Module (1) thermoélectrique suivant l'une des revendications précédentes, dans lequel il est formé au moins dans la surface (2) périphérique intérieure interrompue un espace (11) libre entre des parties (7) intérieures de cadre voisines, qui est rempli d'une matière (13) isolante poreuse.

4. Module (1) thermoélectrique suivant l'une des revendications précédentes dans lequel le manchon (14) de forme instable, prévu au moins sur la surface (2) périphérique intérieure, est un tuyau souple de dilatation qui, à la température ambiante, a une force (15) de précontrainte dirigée dans le sens allant vers la surface (4) périphérique extérieure.

5. Module (1) thermoélectrique suivant la revendication 4, dans lequel le manchon (14) de forme instable a au moins un élément (6) de ressort, qui produit la force (15) de précontrainte.

6. Module (1) thermoélectrique suivant la revendication 4 ou 5, dans lequel le manchon (14) de forme instable est constitué au moins en partie d'au moins l'une des matières suivantes : alliage à mémoire de forme (shape memory alloy - SMA), polymère à mémoire de forme (shape memory polymer - SMP).

7. Module (1) thermoélectrique suivant l'une des revendications 4 à 6, dans lequel, à la température ambiante, la force (5) de précontrainte sur les parties (7) intérieures de cadre est d'au moins 15 N/mm².

8. Module (1) thermoélectrique suivant l'une des revendications 4 à 7, dans lequel, à une température comprise entre 150°C et 250°C sur le manchon (14) de forme instable, la force (15) de précontrainte sur les parties (7) intérieures de cadre est d'au moins 10 N/mm².

9. Module (1) thermoélectrique suivant l'une des revendications précédentes, dans lequel une colle (17) est mise entre le manchon (14) de forme instable et au moins la surface (2) périphérique intérieure.

10. Véhicule (20) ayant un moteur (21) à combustion interne, un système (22) de gaz d'échappement et un système (23) de refroidissement, dans lequel il est prévu un générateur (24) thermoélectrique qui a une pluralité de modules (1) thermoélectriques suivant l'une des revendications précédentes, le système (22) de gaz d'échappement s'étendant à l'extérieur le long de la surface (4) périphérique extérieure du module (1) thermoélectrique et le système (23) de refroidissement s'étendant à l'intérieur et le long de la surface (2) périphérique intérieure du module (1) thermoélectrique.
